Europäisches Patentamt

European Patent Office

Office européen des brevets

(19)

(11) Numéro de publication : **0 158 926**
**B1**

(12)    # FASCICULE DE BREVET EUROPÉEN

(45) Date de publication du fascicule du brevet :
02.03.88

(51) Int. Cl.⁴ : **G 04 F   5/06**, **H 03 H   9/19**

(21) Numéro de dépôt : **85104023.8**

(22) Date de dépôt : **03.04.85**

(54) **Résonateur en mode de cisaillement d'épaisseur.**

(30) Priorité : **06.04.84 CH 1743/84**

(43) Date de publication de la demande :
**23.10.85 Bulletin 85/43**

(45) Mention de la délivrance du brevet :
**02.03.88 Bulletin 88/09**

(84) Etats contractants désignés :
**DE FR GB**

(56) Documents cités :
**EP-A- 0 099 604**
**DE-A- 2 939 844**
**DE-A- 3 220 032**
**GB-A- 2 020 898**
**US-A- 2 635 199**

(73) Titulaire : **ASULAB S.A.**
**Faubourg du Lac 6**
**CH-2501 Bienne (CH)**

(72) Inventeur : **Zingg, Walter**
**Rue des Mornets 11**
**CH-2520 La Neuveville (CH)**

(74) Mandataire : **de Montmollin, Henri et al**
**ICB Ingénieurs Conseils en Brevets SA Passage**
**Max. Meuron 6**
**CH-2001 Neuchâtel (CH)**

## Description

La présente invention a pour objet un résonateur destiné à vibrer en mode de cisaillement d'épaisseur comportant une plaquette de matériau piézo-électrique et des moyens pour exciter la vibration de la plaquette comprenant une première électrode disposée sur une première face de la plaquette, une deuxième électrode disposée en regard de la première électrode sur la deuxième face de ladite plaquette, des moyens de fixation mécanique du résonateur sur un support et des moyens de liaison électrique des électrodes avec un circuit oscillateur comprenant des bornes disposées sur ladite plaquette et des conducteurs reliés auxdites bornes et auxdites électrodes.

Un tel résonateur, dont le brevet US 4 071 797, par exemple, décrit plusieurs formes d'exécution, est généralement associé à un circuit électronique adéquat pour former un oscillateur délivrant un signal alternatif dont la fréquence est très stable. De tels circuits oscillateurs sont utilisés, par exemple, dans les pièces d'horlogerie électroniques dont ils constituent la base de temps.

La vibration d'un tel résonateur est provoquée par le champ électrique alternatif qui est créé entre ses électrodes d'excitation par une tension, également alternative, appliquée à ces électrodes par le circuit électronique auquel elles sont reliées.

L'énergie mécanique nécessaire à l'entretien de cette vibration est bien entendu fournie, sous forme d'énergie électrique, par la source d'alimentation électrique du circuit.

Si cette énergie mécanique restait confinée dans la zone du résonateur située entre les électrodes d'excitation, la quantité d'énergie électrique que la source d'alimentation doit fournir pour entretenir les vibrations serait minimum.

Cependant, il est bien connu qu'une partie de l'énergie mécanique produite dans la zone située entre les électrodes sort de cette zone. Le reste du résonateur vibre donc aussi, avec une amplitude qui diminue exponentiellement à partir de cette zone. L'énergie mécanique associée à cette vibration diminue évidemment de la même manière.

Si les dimensions du résonateur sont suffisamment grandes pour que, à cause de cette diminution exponentielle, l'amplitude de cette vibration soit pratiquement nulle dans la zone de la fixation du résonateur à son support, l'énergie mécanique associée à cette vibration est également pratiquement nulle dans cette zone.

Si par contre les dimensions du résonateur sont relativement faibles, l'amplitude de cette vibration et l'énergie mécanique qui lui est associée ne sont pas nulles dans cette zone de la fixation du résonateur. Cette énergie mécanique se dissipe inutilement dans cette fixation, ce qui diminue le facteur de qualité du résonateur.

Comme la tendance actuelle est de fabriquer des résonateurs ayant des dimensions aussi faibles que possible, de nombreuses solutions ont été proposées pour diminuer l'amplitude de la vibration de la plaquette dans la zone de sa fixation et donc la quantité d'énergie dissipée inutilement dans cette fixation, afin d'obtenir des résonateurs ayant un facteur de qualité élevé malgré leurs petites dimensions.

Le brevet US 4 124 809, par exemple, propose d'amincir les extrémités du résonateur, en dehors de la zone où sont situées les électrodes d'excitation.

La réalisation pratique d'un tel résonateur est cependant compliquée et il ne peut pas être fabriqué en grande série et à bas prix.

Le but de la présente invention est de proposer un résonateur piézo-électrique du type mentionné ci-dessus dans lequel les pertes d'énergie de vibration sont très réduites et qui présente donc un facteur de qualité élevé même si ses dimensions sont faibles, tout en étant facile à fabriquer et donc d'un prix de revient bas.

Ce but est atteint par le résonateur revendiqué.

L'invention va maintenant être décrite à l'aide du dessin dans lequel :
- la figure unique est une vue en plan d'une forme d'exécution du résonateur selon l'invention.

Le résonateur 1 représenté dans cette figure comporte une plaquette en quartz 2 destinée à vibrer de manière prédominante en mode de cisaillement d'épaisseur. Les coupes utilisées pour ce mode de vibration, parmi lesquelles on peut citer les coupes AT et BT, sont bien connues et ne seront pas décrites ici.

La plaquette 2 a la forme générale d'un parallélépipède rectangle dont une des faces principales est seule visible à la figure. L'épaisseur de la plaquette 2 détermine de manière également connue la fréquence propre de vibration du résonateur 1.

Par référence à la disposition de ce résonateur 1 dans la figure, les faces principales de la plaquette 2 seront désignées comme face supérieure et, respectivement, inférieure dans la suite de cette description.

Deux électrodes 3 et 4, destinées à exciter la vibration du résonateur 1, sont disposées en regard l'une de l'autre sur la face supérieure et, respectivement, la face inférieure de la plaquette 2.

Ces électrodes 3 et 4 sont reliées à des bornes de connexion 5, respectivement 6, du résonateur 1 par des conducteurs 7, respectivement 8. Ces bornes 5 et 6 sont destinées à relier électriquement les électrodes 3 et 4 à un circuit oscillateur non représenté. Elles sont généralement aussi utilisées pour fixer mécaniquement le résonateur 1 à un support, également non représenté.

Dans l'exemple représenté à la figure, les bornes 5 et 6 sont situées sur la face supérieure de la plaquette 2 pour faciliter le montage et la connexion du résonateur 1 sur son support.

Le conducteur 7 qui relie la borne 5 à l'électrode 3 comprend deux tronçons 7a et 7b reliés respectivement à l'électrode 3 et à la borne 5 et donc situés tous deux sur la face supérieure de la plaquette 2. Le conducteur 7 comporte également un tronçon 7c situé sur la face inférieure de la plaquette 2 et relié aux tronçons 7a et 7b par deux conducteurs 7d, respectivement 7e, disposés sur les faces latérales de la plaquette 2.

Le conducteur 8 qui relie la borne 6 à l'électrode 4 est formé de deux tronçons 8a et 8b reliés respectivement à l'électrode 4 et à la borne 6 et donc situés respectivement sur la face inférieure et sur la face supérieure de la plaquette 2. Ces deux tronçons 8a et 8b sont reliés par un conducteur 8c disposé sur une face latérale de la plaquette 2.

Les conducteurs 7 et 8 sont disposés de manière que leurs tronçons 7c et 8b se croisent, dans une vue en plan du résonateur 1 telle que celle de la figure, dans une zone désignée par la référence 9, située entre les électrodes 3 et 4 et les bornes 5 et 6. Les parties de ces tronçons 7c et 8b situées en regard l'une de l'autre et délimitant cette zone 9 seront désignées dans la suite de cette description comme des électrodes auxiliaires 7f et, respectivement 8d. La raison de cette désignation sera rendue évidente ci-dessous. Pour les distinguer de ces électrodes auxiliaires 7f et 8d, les électrodes 3 et 4 seront désignées par la suite comme électrodes principales.

Lorsque le résonateur 1 fonctionne, c'est-à-dire lorsque ses bornes 5 et 6 sont reliées à un circuit oscillateur adéquat, les électrodes auxiliaires 7f et 8d sont bien entendu au même potentiel que les électrodes principales 3 et, respectivement 4. Ces électrodes auxiliaires 7f et 8d soumettent donc la plaquette 2, dans la zone 9, à un champ électrique semblable à celui qui est produit par les électrodes principales 3 et 4. Ce champ provoque donc également une vibration en mode de cisaillement d'épaisseur dans la zone 9, vibration qui sera désignée dans la suite de la description comme vibration auxiliaire.

La fréquence de la tension appliquée aux électrodes auxiliaires 7f et 8d étant évidemment identique à celle de la tension appliquée aux électrodes principales 3 et 4, et l'épaisseur de la plaquette 2 étant constante, la fréquence de la vibration auxiliaire est identique à la fréquence de la vibration principale.

Cependant, comme chacune des électrodes auxiliaires 7f et 8d est située sur la face de la plaquette 2 qui est opposée à la face sur laquelle se trouve l'électrode principale 3, respectivement 4, à laquelle elle est reliée, le champ électrique produit par ces électrodes auxiliaires 7f et 8d dans la zone 9 a toujours le sens opposé de celui qui est produit par les électrodes principales 3 et 4. Il en résulte que la vibration auxiliaire est en opposition de phase avec la vibration principale.

La vibration auxiliaire se propage dans le résonateur 1 à partir de la zone 9, et se superpose à la vibration principale qui se propage à partir de la zone des électrodes 3 et 4.

Ces deux vibrations étant en opposition de phase, l'amplitude de la vibration résultant de leur superposition est plus faible que l'amplitude de la plus forte des deux considérées séparément.

Dans la partie du résonateur 1 située entre la zone 9 et la zone des bornes 5 et 6, les vibrations principale et auxiliaire se propagent dans le même sens et s'affaiblissent en suivant la même loi exponentielle. La vibration résultant de leur superposition a donc, dans la zone des bornes 5 et 6, une amplitude résiduelle très faible, et l'énergie mécanique dissipée dans la fixation du résonateur est également très faible.

La présence des électrodes auxiliaires 7f et 8d qui créent dans la zone 9 de la plaquette 2 une vibration auxiliaire en opposition de phase par rapport à la vibration principale qui est créée par les électrodes 3 et 4 permet donc de diminuer fortement la quantité d'énergie mécanique dissipée dans la fixation du résonateur, et d'augmenter notablement son facteur de qualité par rapport à celui d'un résonateur classique non muni de ces électrodes auxiliaires.

La forme et les dimensions de ces électrodes auxiliaires, qui déterminent celles de la zone 9, ne sont pas très critiques. Des essais ont montré que, pour un résonateur destiné à vibrer à une fréquence de 10 MHz, ayant une longueur totale de 6 mm et une largeur totale de 2 mm, la présence d'électrodes auxiliaires telles que les électrodes 7f et 8d ayant une surface comprise entre 1 et 3 % de la surface des électrodes principales, telles que les électrodes 3 et 4, et séparées de celles-ci par une distance de 1 mm environ, provoque une augmentation du facteur de qualité du résonateur de 1,5 à 2 fois par rapport au facteur de qualité d'un résonateur de mêmes dimensions non pourvu de ces électrodes auxiliaires.

La figure illustre également une variante du résonateur selon l'invention. Dans cette variante, une ouverture, située entre les électrodes auxiliaires 7f et 8d et les bornes 5 et 6, traverse toute l'épaisseur de la plaquette 2. Un exemple d'une telle ouverture est représenté en traits mixtes dans la figure, avec la référence 10.

La déposante a constaté que la présence de cette ouverture 10 améliore encore le facteur de qualité du résonateur 1 par rapport à un résonateur identique mais ne présentant pas cette ouverture.

Cette amélioration peut s'expliquer par le fait que cette ouverture 10 restreint la propagation de la vibration résultant de la superposition des vibrations principale et auxiliaire en direction des bornes 5 et 6. En effet, une partie de cette vibration résultante est réfléchie vers les électrodes auxiliaires et principales par la présence de la discontinuité d'impédance acoustique du résonateur créée par cette ouverture 10. L'énergie mécanique de la vibration résultante ainsi réfléchie reste donc « piégée » dans la zone des électrodes, où elle contribue à l'entretien de la vibration du résonateur, et la quantité d'énergie inutilement dissipée dans la fixation du résonateur à son support est encore diminuée.

Cette ouverture 10 peut avoir différentes formes, notamment la forme de fente parallèle à la longueur de la plaquette 2 représentée à la figure. Cette fente peut être fermée à ses deux extrémités, comme cela a été représenté à la figure. Elle pourrait également être ouverte à son extrémité située du côté des bornes 5 et 6. Cette possibilité n'a pas été représentée.

Les dimensions de cette ouverture 10 ne sont pas non plus très critiques. Des essais ont montré qu'une ouverture 10 ayant une dimension de 0,5 à 1,5 mm dans le sens de la longueur de la plaquette 2 et une dimension de 0,2 à 0,5 mm dans le sens de la largeur de cette plaquette, pratiquée dans un résonateur ayant les mêmes dimensions que le résonateur décrit ci-dessus, provoque une augmentation du facteur de qualité de ce résonateur de 1,5 à 2 fois par rapport au facteur de qualité du même résonateur non muni de cette ouverture.

Il est évident que l'invention ne se limite pas à la forme d'exécution et à sa variante décrites à l'aide de la figure. Par exemple, la forme de la plaquette 2 et/ou des électrodes principales 3 et 4 pourrait être différente de celle qui est représentée dans cette figure. De même, les électrodes auxiliaires 7f et 8d, qui sont simplement constituées par des parties des conducteurs 7 et 8 dans la figure, pourraient avoir une forme différente de celle qui est représentée et, notamment, une largeur plus grande ou plus petite que la largeur de ces conducteurs 7 et 8. En outre, les bornes de connexion 5 et 6 pourraient être disposées chacune sur une des faces principales de la plaquette 2. Il en résulterait bien entendu une disposition différente des conducteurs 7 et 8. Enfin, dans l'exemple décrit, les bornes de connexion électrique 5 et 6 du résonateur 1 servent aussi à sa fixation mécanique sur son support. Il serait également possible de prévoir sur ce résonateur des moyens de fixation mécanique distincts des moyens de connexion électriques. Toutes ces modifications ne feraient pas sortir du cadre de l'invention le résonateur auquel elles seraient appliquées.

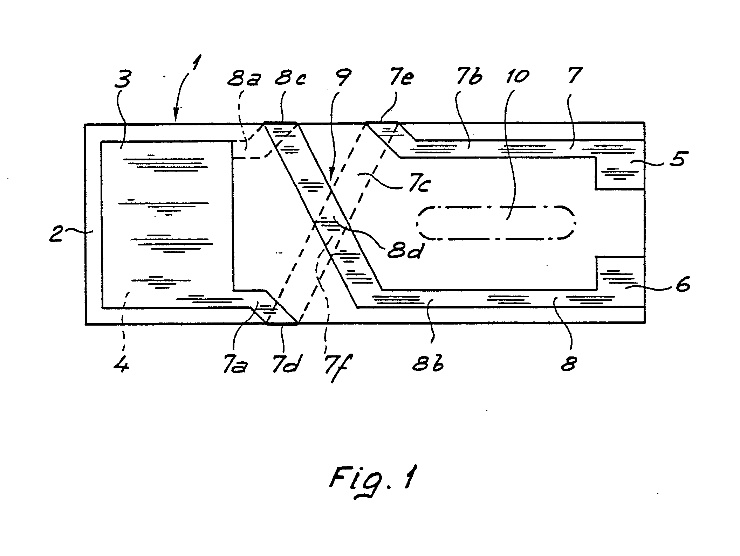

Il faut également noter que la présence d'électrodes d'excitation d'une vibration auxiliaire telles que les électrodes 7f et 8d et/ou d'une ouverture telle que l'ouverture 10 ne complique absolument pas la fabrication des résonateurs selon l'invention. Les résonateurs connus sont en effet couramment fabriqués en grandes séries par des procédés faisant intervenir des dépôts de couches métalliques et des gravages chimiques à travers des masques de protection, procédés qui sont bien connus et ne seront pas décrits ici. Les résonateurs selon l'invention peuvent être fabriqués en utilisant exactement les mêmes procédés. Les électrodes auxiliaires telles que les électrodes 7f et 8d de la figure peuvent être déposées en même temps que les autres parties métalliques du résonateur, et les ouvertures telles que l'ouverture 10 de la figure 1 peuvent être gravées pendant l'opération de découpage des plaquettes telles que la plaquette 2. L'amélioration des caractéristiques des résonateurs apportée par ces électrodes auxiliaires 7f et 8d et cette ouverture 10 est donc obtenue sans augmentation de leur prix de revient.

**Revendications**

1. Résonateur destiné à vibrer en mode de cisaillement d'épaisseur comportant une plaquette (2) de matériau piézo-électrique et des moyens pour produire la vibration de la plaquette comprenant une première électrode (3) disposée sur une première face de la plaquette (2), une deuxième électrode (4) disposée en regard de la première électrode (3) sur la deuxième face de ladite plaquette (2), des moyens de fixation mécanique (5, 6) du résonateur sur un support et des moyens de liaison électrique des électrodes avec un circuit oscillateur comprenant des bornes disposées sur ladite plaquette et des conducteurs reliées auxdites bornes et auxdites électrodes, caractérisé par le fait qu'il comporte en outre une troisième électrode (7f) reliée électriquement à la première électrode (3) et située sur la deuxième face de ladite plaquette (2) entre la deuxième électrode (4) et lesdits moyens de fixation mécanique (5, 6) et une quatrième électrode (8d) reliée électriquement à la deuxième électrode (4) et située en regard de la troisième électrode (7f) sur la première face de ladite plaquette (2), lesdites troisième (7f) et quatrième électrodes (8d) étant destinées à produire une vibration auxiliaire de ladite plaquette (2) en opposition de phase avec la vibration produite par lesdites première (3) et deuxième électrodes (4), pour diminuer l'amplitude de la vibration de la plaquette dans la zone desdits moyens de fixation mécanique (5, 6).

2. Résonateur selon la revendication 1, caractérisé par le fait qu'il comporte en outre une ouverture (10) traversant ladite plaquette (2) dans son épaisseur et disposée entre lesdits moyens de fixation mécanique (5, 6) et lesdites première (3) et deuxième électrodes (4) pour restreindre la propagation desdites vibrations en direction desdits moyens de fixation mécanique (5, 6).

3. Résonateur selon la revendication 2, caractérisé par le fait que ladite plaquette (2) a la forme générale d'un rectangle dans une vue en plan du résonateur (1), lesdites première (3) et deuxième électrodes (4) étant disposées sensiblement à l'une des extrémités de la longueur du rectangle et lesdits moyens de fixation mécanique (5, 6) étant disposés sensiblement à l'autre extrémité de ladite longueur, et que ladite ouverture (10) à la forme d'une fente allongée dans une direction sensiblement parallèle à ladite longueur.

4. Résonateur selon la revendication 3, caractérisé par le fait que ladite fente (10) est fermée à ses deux extrémités.

5. Résonateur selon la revendication 3, caractérisé par le fait que ladite fente (10) est ouverte à son extrémité située du côté desdits moyens de fixation mécanique (5, 6).

6. Résonateur selon l'une des revendications 1 à 5, caractérisé par le fait que lesdits moyens de fixation mécanique et lesdits moyens de liaison électrique sont communs.

**Claims**

1. A resonator adapted to vibrate in a thickness-shear mode, comprising a plate (2) of piezo-electric material and plate vibrating means including a first electrode (3) disposed on a first surface of the plate (2), a second electrode (4) disposed on the second surface of the plate (2) opposite the first electrode, means (5, 6) for fastening the resonator mechanically to a support and means for connecting the electrodes electrically to an oscillator circuit including terminals disposed on said plate and conductors connected to said terminals and to said electrodes, characterized in that it further comprises a third electrode (7f) connected electrically to the first electrode (3) and disposed on the second surface of said plate (2) between the second electrode (4) and said mechanical fastening means (5, 6) and a fourth electrode (8d) connected electrically to the second electrode (4) and disposed opposite the third electrode (7f) on the first surface of said plate (2), said third (7f) and fourth electrodes (8d) being intended to generate an auxiliary vibration of said plate (2) in opposition of phase with respect to the vibration generated by said first (2) and second electrodes (3) for decreasing the amplitude of the vibration of the plate in the zone of said mechanical fastening means (5, 6).

2. The resonator of claim 1, characterized in that it further comprises an aperture (10) extending through the thickness of said plate (2) between said mechanical fastening means (5, 6) and said first (3) and second electrodes (4) to restrict said vibrations from propagating towards said mechanical fastening means (5, 6).

3. The resonator of claim 2, characterized in that said plate (2) has the general shape of a rectangle when viewed in a plan view of the resonator (1), said first (3) and second electrodes (4) being arranged substantially at one end of the length of the rectangle and said mechanical fastening means (5, 6) being arranged substantially at the other end of said length, and in that said aperture (10) has the shape of a slot extending in a direction substantially parallel to said length.

4. The resonator of claim 3, characterized in that said slot (10) is closed at its both ends.

5. The resonator of claim 3, characterized in that said slot (10) is open at its end nearest said mechanical fastening means (5, 6).

6. The resonator of one of claims 1 to 5, characterized in that said fastening means and said electrical connecting means are common.

**Patentansprüche**

1. Dickenscherschwingungs-Modus-Resonator, umfassend eine Platte (2) aus piezoelektrischem Werkstoff und Mittel zur Erzeugung der Plattenschwingung, bestehend aus einer ersten auf einer ersten Seite der Platte (2) angeordneten Elektrode (3), einer zweiten, der ersten Elektrode auf der zweiten Seite der genannten Platte (2) gegenüberliegenden Elektrode (4), mechanische Befestigungsmittel (5, 6) des Resonators auf einem Halter und Mittel zur elektrischen Verbindung der Elektroden mit einem Schwingungskreis, umfassend auf der genannten Platte angeordnete Anschlüsse und Leiter, die mit den genannten Anschlüssen und den genannten Elektroden verbunden sind, dadurch gekennzeichnet, dass er ferner eine dritte Elektrode umfasst (7f), die mit der ersten Elektrode (3) elektrisch verbunden und auf der zweiten Seite der genannten Platte (2) zwischen der zweiten Elektrode (4) und den genannten mechanischen Befestigungsmitteln (5, 6) angeordnet ist, und eine vierte Elektrode (8d), die elektrisch mit der zweiten Elektrode (4) verbunden und gegenüber der dritten Elektrode (7f) auf der ersten Seite der genannten Platte (2) angeordnet ist, wobei die genannte dritte (7f) und die genannte vierte Elektrode (8d) die Aufgabe haben, eine gegenphasig zu der von der genannten ersten (3) und der genannten zweiten Elektrode (4) erzeugten Schwingung verlaufende Hilfsschwingung der genannten Platte (2) zu erzeugen, um die Schwingungsweite der Platte in der Zone der genannten mechanischen Befestigungsmittel (5, 6) zu verringern.

2. Resonator gemäss Anspruch 1, dadurch gekennzeichnet, dass er ferner eine Oeffnung (10) umfasst, die die genannte Platte (2) in ihrer Dicke durchquert und zwischen den genannten mechanischen Befestigungsmitteln (5, 6) und der genannten ersten (3) und zweiten Elektrode (4) angeordnet ist, um die Ausbreitung der genannten Schwingungen in Richtung der genannten mechanischen Befestigungsmittel (5, 6) einzuschränken.

3. Resonator gemäss Anspruch 2, dadurch gekennzeichnet, dass die genannte Platte (2) in der Draufsicht des Resonators (1) die allgemeine Form eines Rechtecks hat, wobei die genannte erste (3) und die genannte zweite Elektrode (4) an einem Ende der Länge des Rechtecks angeordnet sind und die genannten mechanischen Befestigungsmittel (5, 6) am anderen Ende der genannten Länge angeordnet sind, und dadurch, dass die genannte Oeffnung (10) die Form eines länglichen Schlitzes hat, der parallel zur genannten Länge verläuft.

4. Resonator gemäss Anspruch 3, dadurch gekennzeichnet, dass der genannte Schlitz (10) an seinen beiden Enden geschlossen ist.

5. Resonator gemäss Anspruch 3, dadurch gekennzeichnet, dass der genannte Schlitz (10) an seinem den genannten mechanischen Befestigungsmitteln (5, 6) zugewandten Ende offen ist.

6. Resonator gemäss einem der Ansprüche 1 bis 5, dadurch gekennzeichnet, dass die genannten mechanischen Befestigungsmittel und die genannten elektrischen Verbindungsmittel gemeinsam sind.

Fig. 1